# EUROPÄISCHE PATENTANMELDUNG

(11) **EP 4 502 629 A1**
(43) Veröffentlichungstag der Anmeldung: **05.02.2025**
(21) Anmeldenummer: 23189760.4
(22) Anmeldetag: 04.08.2023
(51) Int. Cl.: G01R 31/26, G01R 31/28, G01R 31/71, H05K 13/08

(54) **VERFAHREN ZUM BESTIMMEN EINES ZUSTANDS EINES ELEKTRONISCHEN BAUTEILS MITTELS EINER ZUSTANDSBESTIMMUNGSVORRICHTUNG, COMPUTERPROGRAMMPRODUKT, COMPUTERLESBARES SPEICHERMEDIUM SOWIE ZUSTANDSBESTIMMUNGSVORRICHTUNG**

(71) Anmelder: Siemens Aktiengesellschaft, 80333 München (DE)
(72) Erfinder: DOBS, Tom, 10553 Berlin (DE); STROGIES, Jörg, 14163 Berlin (DE); WILKE, Klaus, 12527 Berlin (DE); MAGER, Christiane, 71101 Schönaich (DE); RATCHEV, Roumen, 70499 Stuttgart (DE); MANIAR, Youssef, 70442 Stuttgart (DE); GLEICHAUF, Jonas, 70193 Stuttgart (DE); ELSOTOHY, Mariam, 10115 Berlin (DE); SEHR, Frederic, 710559 Berlin (DE); JAESCHKE, Johannes, 14052 Berlin (DE); KAMM, Simon, 71116 Gärtringen (DE); ARTELT, Maurice Paul, 70178 Stuttgart (DE); JAZDI, Nasser, 71272 Renningen (DE); WEYRICH, Michael, 70839 Gerlingen (DE); EBRAHIMI, Puya, 14199 Berlin (DE); LAMBRECHT, Jens, 12047 Berlin (DE)
(74) Vertreter: Hofstetter, Schurack & Partner

(57) **Zusammenfassung**

Die Erfindung betrifft ein Verfahren zum Bestimmen eines Zustands (16) eines elektronischen Bauteils (18) mittels einer Zustandsbestimmungsvorrichtung (10), mit den Schritten:
- Bereitstellen von Produktionsdaten (20) des elektronischen Bauteils (18) für eine elektronische Recheneinrichtung (14) der Zustandsbestimmungsvorrichtung (10);
- Erfassen von zumindest einem das elektronische Bauteil (18) aktuell charakterisierenden Parameters (26) mittels einer Erfassungseinrichtung (12) der Zustandsbestimmungsvorrichtung (10); und
- Bestimmen des Zustands (16) in Abhängigkeit von den bereitgestellten Produktionsdaten (20) und dem zumindest einen das elektronische Bauteil (18) aktuell charakterisierenden Parameter (26) mittels der elektronischen Recheneinrichtung (14).Ferner betrifft die Erfindung ein Computerprogrammprodukt, ein computerlesbares Speichermedium sowie eine Zustandsbestimmungsvorrichtung (10).

## Beschreibung

Die Erfindung betrifft ein Verfahren zum Bestimmen eines Zustands eines elektronischen Bauteils mittels einer Zustandsbestimmungsvorrichtung gemäß dem geltenden Patentanspruch 1. Ferner betrifft die Erfindung ein entsprechendes Computerprogrammprodukt, ein entsprechendes computerlesbares Speichermedium sowie eine entsprechende Zustandsbestimmungsvorrichtung.

Elektronische Systeme, insbesondere spezifisch die Aufbau- und Verbindungstechnik von Elektronik-Baugruppen unterliegen im Betrieb, welcher auch als Feldbetrieb bezeichnet werden kann, einer kontinuierlichen Alterung/Degradation durch intrinsische und extrinsische Belastungen, was final zum Ausfall führen kann. Beispielhaft sind einige Belastungen aufgeführt wie Temperatur beziehungsweise Temperaturwechsel durch Verlustleistung oder Umgebung, mechanische Belastungen wie mechanischer Schock oder Schwingungen, Schadgase oder Feuchte, hohe Stromdichte durch die Bauelemente und Leiterzüge oder dergleichen. Speziell sicherheitsrelevante Elektroniksysteme dürfen im Feld nicht spontan ausfallen, so dass diese Elektroniksysteme ihre elektrischen Funktionen während der Nutzungsphase vollumfänglich erfüllen müssen.

Aus dem Stand der Technik ist hierzu bereits bekannt, dass Baugruppen bezüglich ihrer Anforderungen im Feld ausgelegt werden. Beispielsweise sicherheitsrelevante Elektronik wird entsprechend überausgelegt. Die für die Auslegung erforderlichen Daten zu Degradationsverläufen beziehungsweise - mechanismen werden aus modellhaften Simulationen sowie experimentellen Zuverlässigkeitstests gewonnen. Dabei werden die potentiell im Feldbetrieb auftretenden Belastungsszenarien, die so genannten Mission Profiles, berücksichtigt. Neben der Überauslegung von Elektroniksystemen wird häufig Hardware-Redundanz realisiert, was insbesondere bedeutet, dass mehrere gleiche Baugruppen beziehungsweise Funktionen parallel bereitgestellt werden, so dass beim Ausfall einer elektronischen Funktionalität, beispielsweise auch einer Baugruppe, eine weitere die ursprüngliche ersetzt. Des Weiteren sind Methoden der Zustandsüberwachung mittels Zustandsindikatoren durch beispielsweise Zählen von wirkenden Belastungszyklen und durch Parameterdriftauswertung bekannt und werden zur Ausfallvorhersage genutzt. Es wird hierbei gegebenenfalls eine frühzeitige Wartung bis zum prophylaktischen Austausch von Elektroniksystemen realisiert, um einem Ausfall im Feldbetrieb vorzubeugen.

Aufgabe der vorliegenden Erfindung ist es, ein Verfahren, ein entsprechendes Computerprogrammprodukt, ein entsprechendes computerlesbares Speichermedium sowie eine entsprechende Zustandsbestimmungsvorrichtung zu schaffen, mittels welchen zuverlässig ein Zustand des elektronischen Bauteils, insbesondere im so genannten Feld, bestimmt werden kann.

Diese Aufgabe wird durch ein Verfahren, ein entsprechendes Computerprogrammprodukt, ein entsprechendes computerlesbares Speichermedium sowie eine entsprechende Zustandsbestimmungsvorrichtung gemäß den unabhängigen Patentansprüchen gelöst. Vorteilhafte Ausgestaltungsformen sind in den Unteransprüchen angegeben.

Ein Aspekt der Erfindung betrifft ein Verfahren zum Bestimmen eines Zustands eines elektronischen Bauteils mittels einer Zustandsbestimmungsvorrichtung. Es erfolgt das Bereitstellen von Produktionsdaten des elektronischen Bauteils für eine elektronische Recheneinrichtung der Zustandsbestimmungsvorrichtung. Es wird zumindest ein das elektronische Bauteil aktuell charakterisierender Parameter mittels einer Erfassungseinrichtung der Zustandsbestimmungsvorrichtung erfasst. Der Zustand wird dann in Abhängigkeit von den bereitgestellten Produktionsdaten und dem zumindest einen das elektronische Bauteil aktuell charakterisierende Parameter mittels der elektronischen Recheneinrichtung bestimmt.

Insbesondere kann somit ein methodischer Ansatz für eine kontinuierliche Information über den jeweils vorhandenen Systemzustand während der Nutzungsphase des elektronischen Bauteils angewendet werden. Somit ist es ermöglicht, dass adaptiv die Zustandsbestimmung durchgeführt werden kann.

Insbesondere ist beispielsweise eine hybride KI (künstliche Intelligenz)-basierte Systemmodellierung zur Ermittlung des adaptiven Systemzustands elektronischer Systeme auf Basis statischer Daten und dynamischer Datenflüsse bereitgestellt. Unter den statischen Daten sind insbesondere vorliegend die Produktionsdaten, bei welchen es sich insbesondere um zuverlässigkeitsrelevante Produktionsdaten handelt, zu verstehen. Unter den dynamischen Daten sind vorliegend insbesondere der das elektronische Bauteil aktuell charakterisierende Parameter zu verstehen.

Insbesondere werden somit die statischen Daten ausgewertet, um eine zuverlässigkeitsrelevante Bewertungsgröße für ein reproduziertes elektronisches Bauteil zu ermitteln. Es werden dann die dynamischen Daten der gesamten Nutzungszeit des elektronischen Bauteils im Feld, insbesondere funktionellelektrische Betriebsdaten, erfasst und ausgewertet. Alterungsabhängige Degradationseigenschaften können dann wiederum entsprechend abgebildet werden und können mit Betriebs- und Belastungsdaten an die realen Verhältnisse angepasst werden. Durch einen entsprechenden Algorithmus, insbesondere ausgebildet in der elektronischen Recheneinrichtung, werden beide Datenpfade kombiniert und der Zustand des elektronischen Bauteils insbesondere kontinuierlich bestimmt.

Durch diese Kombination von Produktions- und Felddaten in dem hybriden Systemmodell wird insbesondere eine hohe Sensitivität der Zustandsbestimmung realisiert. Es werden unter anderem Schwankungen im Produktionsprozess und einsatzortabhängige Belastungen berücksichtigt. Die Überauslegung von sicherheitsrelevanten Elektroniksystemen kann durch die Methode beziehungsweise das vorgeschlagene Verfahren reduziert werden. Somit können Ressourcen geschont werden. Die Auswirkung veränderter Einsatzbedingungen, beispielsweise Abweichungen gegenüber den Mission Profiles auf die Lebensdauer werden adaptiv erfasst. Ferner kann rechtzeitig eine Wartung der Elektroniksysteme erfolgen, die nicht nach zuvor festgelegten Zeitregimen, sondern zustandsadaptiv erfolgt. Bei Bedarf kann das elektronische Bauteil auch in einen so genannten schonenden Betriebszustand versetzt werden, um die Zeit bis zu einer möglichen Wartung ohne Systemausfall zu überbrücken. Ferner ermöglicht die stetige Auswertung von Felddaten das Erkennen von ungewöhnlichen Ereignissen wie zum Beispiel Manipulationen am elektronischen Bauteil oder spontane, nicht vorhersehbare Belastungsereignisse. Im Unterschied zwischen den bereits bekannten Lösungen kann der Normalbereich der Messdaten für jedes überwachte elektronische Bauteil beziehungsweise elektronisches Bauteil unter Berücksichtigung der individuellen Fertigungsqualität bestimmt werden.

Unter elektronischem Bauteil kann vorliegend insbesondere eine Platine mit beispielsweise Kondensatoren, Prozessoren, elektrischen Widerständen oder dergleichen angesehen werden. Beispielsweise können auf der Platine entsprechende Leiterbahnen zum Kontaktieren der einzelnen Bauteilelemente bereitgestellt werden. Die einzelnen Bauteilelemente können wiederum über einen Lötprozess mit der Platine und auch untereinander somit verbunden werden. Ferner kann unter elektronischem Bauteil vorliegend auch das Zusammenführen mehrerer solcher Platinen mit den entsprechenden Bauteilelementen angesehen werden. Insbesondere kann somit auch eine Bauteilgruppe als elektronisches Bauteil angesehen werden. Diese Aufzählung ist rein beispielhaft und keinesfalls abschließend zu verstehen. Es sind auch weitere Baugruppen beziehungsweise Unterbaugruppen als elektronisches Bauteil gemäß der vorliegenden Erfindung anzusehen.

Gemäß einer vorteilhaften Ausgestaltungsform wird in Abhängigkeit von dem bestimmten Zustand eine Ausfallwahrscheinlichkeit des elektronischen Bauteils und/oder eine Lebensdauerprognose des elektronischen Bauteils bestimmt. Beispielsweise kann vorhergesagt werden, wann das elektronische Bauteil im Wesentlichen, insbesondere zumindest unter den derzeit herrschenden Bedingungen, ausfallen wird. Ferner kann auch eine Lebensdauerprognose, beispielsweise in vorgegebenen Zeitabständen, beispielsweise Monate oder Jahre, entsprechend bewertet werden. Beispielsweise kann vorhergesagt werden, dass mit einer gewissen Wahrscheinlichkeit in einem ermittelten Jahr das elektronische Bauteil ausfallen wird. Somit kann zuverlässig der aktuelle Zustand bestimmt werden und für eine Ausfallwahrscheinlichkeit beziehungsweise Lebensdauerprognose herangezogen werden.

Eine weitere vorteilhafte Ausgestaltungsform sieht vor, dass die elektronische Recheneinrichtung mit einer künstlichen Intelligenz bereitgestellt wird. Die künstliche Intelligenz kann auch als KI bezeichnet werden. Bei der künstlichen Intelligenz kann es sich beispielsweise um ein maschinelles Lernsystem handeln. Ferner kann es sich bei der künstlichen Intelligenz um ein neuronales Netzwerk handeln. Das neuronale Netzwerk kann beispielsweise in Form eines faltenden neuronalen Netzwerks (Convolutional Neural Network - CNN) bereitgestellt werden. Somit ist es ermöglicht, dass adaptiv die Zustandsbestimmung durchgeführt werden kann. Ferner kann die künstliche Intelligenz somit lernen und sich beispielsweise an zukünftige Gegebenheiten beispielsweise durch Änderung entsprechender Gewichte innerhalb der künstlichen Intelligenz adaptiert werden. Somit ist eine zuverlässige Bestimmung des Zustands des elektronischen Bauteils ermöglicht.

Ebenfalls vorteilhaft ist, wenn als Produktionsdaten qualitätssichernde Daten während einer Fertigung des elektronischen Bauteils bereitgestellt werden. Beispielsweise werden die Produktionsdaten bereits während der Produktion erfasst. Bei den qualitätssichernden Daten kann es sich insbesondere um Produktionsdaten handeln, welche auch für eine Qualitätssicherung herangezogen werden. Bei diesen Produktionsdaten handelt es sich um Daten, welche beispielsweise innerhalb der Produktionsanlage bereits erfasst werden. Diese Daten werden nun zusätzlich genutzt, um auch eine Zustandsbestimmung durchführen zu können.

Weiterhin vorteilhaft ist, wenn mittels einer optischen Erfassungseinrichtung und/oder mittels einer röntgenstrahlungsbasierten Erfassungseinrichtung und/oder mittels einer spannungsbasierten Erfassungseinrichtung die Produktionsdaten erfasst werden. Beispielsweise kann die optische Erfassungseinrichtung als Kamera oder Lidarsensoreinrichtung ausgebildet sein. Insbesondere können AOI (Automated optical Inspection), SPI (Solder paste Inspection) sowie AXI (Automated X-Ray Inspection) genutzt werden. Mittels der optischen Erfassungseinrichtung können beispielsweise entsprechende Verortungen der Einzelbauteile auf einer Platine erfasst werden. Mittels der röntgenstrahlenbasierten Erfassung können beispielsweise Lötpunkte beziehungsweise Lötstellen auf einen korrekten Zustand hin überprüft werden. Des Weiteren können beispielsweise entsprechende Spannungen an Bauteile angelegt werden, wodurch dann, beispielsweise auf Basis eines elektrischen Widerstands, überprüft werden kann, ob eine korrekte Fertigung des elektronischen Bauteils durchgeführt ist. Somit kann zuverlässig der Zustand bestimmt werden.

Ebenfalls vorteilhaft ist, wenn als Produktionsparameter eine Nassschichtdicke einer Lotpaste des elektronischen Bauteils und/oder ein Reflow-Temperaturprofil eines Lötprozesses des elektronischen Bauteils und/oder ein Abstehen eines Bauteils beim elektronischen Bauteil und/oder eine Verkippung des Bauteils beim elektronischen Bauteil und/oder eine Ausprägung eines Lötmeniskus am elektronischen Bauteil und/oder eine Lötstellenqualität erfasst werden. Insbesondere kann somit eine sehr detailreiche Bewertung des elektronischen Bauteils bereits während der Fertigung beziehungsweise Produktion durchgeführt werden. Diese Produktionsdaten können dann wiederum genutzt werden, um eine entsprechende Auswertung durchzuführen. Auf Basis der sehr detailreichen Produktionsdaten kann somit zuverlässig auf den Zustand des elektronischen Bauteils geschlossen werden. Es ist selbstverständlich, dass noch weitere Daten des elektronischen Bauteils erfasst werden können und zur Bestimmung des Zustands herangezogen werden können.

Eine weitere vorteilhafte Ausgestaltungsform sieht vor, dass für das elektronische Bauteil ein mathematisches Modell für die Ausfallwahrscheinlichkeit auf Basis von vorgegebenen Abhängigkeiten bereitgestellt wird und die Produktionsdaten in Abhängigkeit von dem mathematischen Modell ausgewertet werden. Insbesondere werden somit in dem statischen Datenpfad qualitätsrelevante Inspektionsdaten aus der Elektronikfertigung ausgewertet, um eine zuverlässigkeitsrelevante Bewertungsgröße für jedes produzierte elektronische Bauteil zu ermitteln. Dazu wird ein Modell, insbesondere mathematisches Modell, erstellt, das eine Abhängigkeit des Ausfallzeitpunkts einer Baugruppe von Produktions- und Inspektionsparametern herstellt. Insbesondere können somit beispielsweise vorgegebene Eigenschaften wie beispielsweise Lötmaterial, elektrische Widerstände von entsprechenden Bauteilen, bereits mit in das mathematische Modell einfließen und somit eine detaillierte Auswertung unter Berücksichtigung der Produktionsparameter durchgeführt werden. Somit können über das mathematische Modell Vergleichsparameter bereitgestellt werden, auf Basis derer die individuellen Produktionsdaten bewertet werden können.

Weiterhin vorteilhaft ist, wenn als der das elektronische Bauteil aktuell charakterisierende Parameter ein Umgebungsparameter, beispielsweise eine Umgebungstemperatur, eine Umgebungsfeuchte oder Vibrationen, des elektronischen Bauteils und/oder aktuelle elektrische Betriebsdaten des elektronischen Bauteils erfasst werden. Insbesondere können somit elektrische Funktionsdaten, wie zum Beispiel elektrische Spannungen und/oder Umweltdaten, wie zum Beispiel die Umgebungstemperatur des elektronischen Bauteils, entsprechend berücksichtigt werden. Bei diesen Daten handelt es sich insbesondere um aktuelle Parameter, welche Einfluss auf die Degradation beziehungsweise Alterung des elektronischen Bauteils im Feld haben. Auf Basis dieser Parameter findet nun die Zustandsbestimmung statt.

Ferner hat es sich als vorteilhaft erwiesen, wenn der Zustand des elektronischen Bauteils kontinuierlich bestimmt wird. Insbesondere findet somit eine kontinuierliche Anpassung der Zustandsbestimmung statt. Insbesondere kann somit auf Basis von vergangenen Zustandsbestimmungen und auf Basis der aktuellen Daten eine zuverlässige Prognose des Zustands ermittelt werden. Durch die kontinuierliche Überwachung kann einem Nutzer des elektronischen Bauteils somit zuverlässig die Lebensdauer beziehungsweise Ausfallwahrscheinlichkeit mitgeteilt werden.

Gemäß einer weiteren vorteilhaften Ausgestaltungsform wird zusätzlich ein Gesamtzustand eines elektronischen Systems mit zumindest einem ersten elektronischen Bauteil und einem zweiten elektronischen Bauteil in Abhängigkeit einer jeweiligen Zustandsbestimmung der elektronischen Bauteile bestimmt. Beispielsweise kann ein elektronisches System aus den zumindest zwei elektronischen Bauteilen ausgebildet sein. Das erste elektronische Bauteil kann einen ersten Zustand aufweisen und das zweite elektronische Bauteil kann einen zweiten Zustand aufweisen. Je nach Nutzung des elektronischen Systems kann nun mittels des erfindungsgemäßen Verfahrens auch ein Gesamtzustand des elektronischen Systems s bewertet werden. Somit kann die Lebensdauer des elektronischen Systems zuverlässig bestimmt werden. Es kann dabei beispielsweise vorgesehen sein, dass jedem elektronischen Bauteil ein jeweiliges spezifisches Gewicht innerhalb der Gesamtbestimmung zugeteilt wird. Das jeweilige Gewicht kann beispielsweise abhängig von einer Nutzung innerhalb des elektronischen Systems vorgegeben werden.

Weiterhin vorteilhaft ist, wenn in Abhängigkeit von der Bestimmung des Zustands eine Wartungsempfehlung des elektronischen Bauteils erzeugt wird. Die Wartungsempfehlung kann insbesondere in Form einer Wartungsnachricht ausgegeben werden. Beispielsweise kann, insbesondere mit einem gewissen Sicherheitspuffer vor einem bestimmten Ausfallzeitpunkt, bereits eine Wartungsnachricht erzeugt werden, welche einem Nutzer mitgeteilt wird. Somit ist es ermöglicht, dass ein Ausfall des elektronischen Bauteils verhindert werden kann, da bereits frühzeitig eine Wartungsempfehlung ausgesprochen wird.

In einer weiteren vorteilhaften Ausgestaltungsform kann vorgesehen sein, dass in Abhängigkeit von der Bestimmung des Zustands eine Betriebsart des elektronischen Bauteils adaptiert wird. Beispielsweise kann das elektronische Bauteil mit geringeren Zyklen belastet werden. Hierbei können sowohl Belastungszyklen als auch Schaltzyklen angepasst werden. Es ist selbstverständlich, dass je nach Art des elektronischen Bauteils eine individuelle Anpassung durchgeführt werden kann, Insbesondere kann somit eine Betriebsart des elektronischen Bauteils adaptiert werden. Beispielsweise kann eine schonendere Betriebsart des elektronischen Bauteils eingestellt werden.

Bei dem vorgestellten Verfahren handelt es sich insbesondere um ein computerimplementiertes Verfahren. Daher betrifft ein weiterer Aspekt der Erfindung ein Computerprogrammprodukt mit Programmcodemitteln, welche eine elektronische Recheneinrichtung dazu veranlassen, wenn die Programmcodemittel von der elektronischen Recheneinrichtung abgearbeitet werden, ein Verfahren nach dem vorhergehenden Aspekt durchzuführen.

Ein nochmals weiterer Aspekt der Erfindung betrifft daher auch ein computerlesbares Speichermedium mit einem Computerprogrammprodukt nach dem vorhergehenden Aspekt.

Ebenfalls betrifft die Erfindung eine Zustandsbestimmungsvorrichtung zum Bestimmen eines Zustands eines elektronischen Bauteils, mit zumindest einer elektronischen Recheneinrichtung und einer Erfassungseinrichtung, wobei die Zustandsbestimmungsvorrichtung zum Durchführen eines Verfahrens nach dem vorhergehenden Aspekt ausgebildet ist. Insbesondere wird das Verfahren mittels der Zustandsbestimmungsvorrichtung durchgeführt.

Bei der Erfassungseinrichtung kann es sich beispielsweise um einen Temperatursensor, eine Kamera oder eine Spannungssensorik handeln. Es sind selbstverständlich auch weitere Erfassungseinrichtungen möglich, welche den aktuell charakterisierenden Parameter des elektronischen Bauteils erfassen können. Dabei kann die Erfassungseinrichtung als Teil des elektronischen Bauteils selbst, beispielsweise auf Basis von Selbstdiagnosesoftware oder -hardware, oder auch extern zum elektronischen Bauteil bereitgestellt werden.

Unter einer Recheneinheit/elektronischer Recheneinrichtung kann insbesondere ein Datenverarbeitungsgerät verstanden werden, das einen Verarbeitungsschaltkreis enthält. Die Recheneinheit kann also insbesondere Daten zur Durchführung von Rechenoperationen verarbeiten. Darunter fallen gegebenenfalls auch Operationen, um indizierte Zugriffe auf eine Datenstruktur, beispielsweise eine Umsetzungstabelle, LUT (englisch: "look-up table"), durchzuführen.

Die Recheneinheit kann insbesondere einen oder mehrere Computer, einen oder mehrere Mikrocontroller und/oder einen oder mehrere integrierte Schaltkreise enthalten, beispielsweise eine oder mehrere anwendungsspezifische integrierte Schaltungen, ASIC (englisch: "application-specific integrated circuit"), eines oder mehrere feldprogrammierbare Gate-Arrays, FPGA, und/oder eines oder mehrere Einchipsysteme, SoC (englisch: "system on a chip"). Die Recheneinheit kann auch einen oder mehrere Prozessoren, beispielsweise einen oder mehrere Mikroprozessoren, eine oder mehrere zentrale Prozessoreinheiten, CPU (englisch: "central processing unit"), eine oder mehrere Grafikprozessoreinheiten, GPU (englisch: "graphics processing unit") und/oder einen oder mehrere Signalprozessoren, insbesondere einen oder mehrere Digitalsignalprozessoren, DSP, enthalten. Die Recheneinheit kann auch einen physischen oder einen virtuellen Verbund von Computern oder sonstigen der genannten Einheiten beinhalten.

In verschiedenen Ausführungsbeispielen beinhaltet die Recheneinheit eine oder mehrere Hardware- und/oder Softwareschnittstellen und/oder eine oder mehrere Speichereinheiten.

Eine Speichereinheit kann als flüchtiger Datenspeicher, beispielsweise als dynamischer Speicher mit wahlfreiem Zugriff, DRAM (englisch: "dynamic random access memory") oder statischer Speicher mit wahlfreiem Zugriff, SRAM (englisch: "static random access memory"), oder als nicht-flüchtiger Datenspeicher, beispielsweise als Festwertspeicher, ROM (englisch: "read-only memory"), als programmierbarer Festwertspeicher, PROM (englisch: "programmable read-only memory"), als löschbarer programmierbarer Festwertspeicher, EPROM (englisch: "erasable programmable read-only memory"), als elektrisch löschbarer programmierbarer Festwertspeicher, EEPROM (englisch: "electrically erasable programmable read-only memory"), als Flash-Speicher oder Flash-EEPROM, als ferroelektrischer Speicher mit wahlfreiem Zugriff, FRAM (englisch: "ferroelectric random access memory"), als magnetoresistiver Speicher mit wahlfreiem Zugriff, MRAM (englisch: "magnetoresistive random access memory") oder als Phasenänderungsspeicher mit wahlfreiem Zugriff, PCR_AM (englisch: "phase-change random access memory"), ausgestaltet sein.

Hier und im Folgenden kann ein künstliches neuronales Netzwerk als Softwarecode verstanden werden, der auf einem computerlesbaren Speichermedium gespeichert ist und eines oder mehrere vernetzte künstliche Neuronen repräsentiert beziehungsweise deren Funktion nachbilden kann. Der Softwarecode kann dabei auch mehrere Softwarecodekomponenten beinhalten, die beispielsweise unterschiedliche Funktionen haben können. Insbesondere kann ein künstliches neuronales Netzwerk ein nichlineares Modell oder einen nichtlinearen Algorithmus implementieren, das beziehungsweise der eine Eingabe auf eine Ausgabe abbildet, wobei die Eingabe durch einen Eingangsmerkmalsvektor oder eine Eingangssequenz gegeben ist und die Ausgabe beispielsweise eine ausgegebenen Kategorie für eine Klassifizierungsaufgabe, einen oder mehrere prädizierte Werte oder eine prädizierte Sequenz beinhalten kann.

Für Anwendungsfälle oder Anwendungssituationen, die sich bei dem Verfahren ergeben können und die hier nicht explizit beschrieben sind, kann vorgesehen sein, dass gemäß dem Verfahren eine Fehlermeldung und/oder eine Aufforderung zur Eingabe einer Nutzerrückmeldung ausgegeben und/oder eine Standardeinstellung und/oder ein vorbestimmter Initialzustand eingestellt wird.

Unabhängig vom grammatikalischen Geschlecht eines bestimmten Begriffes sind Personen mit männlicher, weiblicher oder anderer Geschlechteridentität mit umfasst.

Weitere Merkmale der Erfindung ergeben sich aus den Ansprüchen, den Figuren und der Figurenbeschreibung. Die vorstehend in der Beschreibung genannten Merkmale und Merkmalskombinationen sowie die nachfolgend in der Figurenbeschreibung genannten und/oder in den Figuren gezeigten Merkmale und Merkmalskombinationen können nicht nur in der jeweils angegebenen Kombination, sondern auch in anderen Kombinationen von der Erfindung umfasst sein. Es können insbesondere auch Ausführungen und Merkmalskombinationen von der Erfindung umfasst sein, die nicht alle Merkmale eines ursprünglich formulierten Anspruchs aufweisen. Es können darüber hinaus Ausführungen und Merkmalskombinationen von der Erfindung umfasst, die über die in den Rückbezügen der Ansprüche dargelegten Merkmalskombinationen hinausgehen oder von diesen abweichen.

Die Erfindung wird im Folgenden anhand konkreter Ausführungsbeispiele und zugehöriger schematischer Zeichnungen näher erläutert. In den Figuren können gleiche oder funktionsgleiche Elemente mit denselben Bezugszeichen versehen sein. Die Beschreibung gleicher oder funktionsgleicher Elemente wird gegebenenfalls nicht notwendigerweise bezüglich verschiedener Figuren wiederholt.

Dabei zeigen:

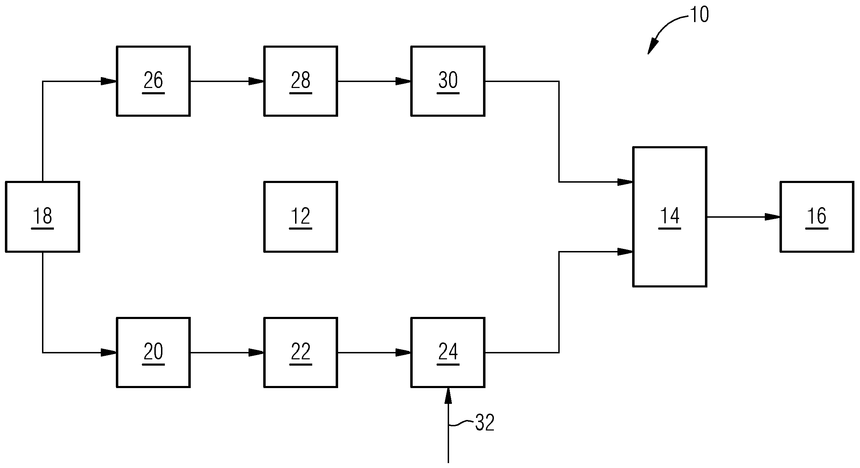

- FIG 1: ein schematisches Blockschaltbild gemäß einer Ausführungsform einer Zustandsbestimmungsvorrichtung.

In den Figuren sind gleiche oder funktionsgleiche Elemente mit den gleichen Bezugszeichen versehen.

FIG 1 zeigt ein schematisches Blockschaltbild gemäß einer Ausführungsform einer Zustandsbestimmungsvorrichtung 10. Die Zustandsbestimmungsvorrichtung 10 weist zumindest eine Erfassungseinrichtung 12 sowie eine elektronische Recheneinrichtung 14 auf. Die elektronische Recheneinrichtung 14 kann beispielsweise in Form einer künstlichen Intelligenz bereitgestellt werden. Die Zustandsbestimmungsvorrichtung 10 ist zum Bestimmen eines Zustands 16 eines elektronischen Bauteils 18 ausgebildet. Hierzu werden Produktionsdaten 20 des elektronischen Bauteils 18 für die elektronische Recheneinrichtung 14 bereitgestellt. Im vorliegenden Ausführungsbeispiel ist insbesondere für die Produktionsdaten 20 ferner eine Datenakquise und Vorverarbeitung 22 sowie ein Bewertungsalgorithmus 24 dargestellt, wobei der Bewertungsalgorithmus insbesondere in Form eines mathematischen Modells 24 bereitgestellt wird.

Ferner erfolgt das Erfassen von zumindest ein das elektronische Bauteil 18 aktuell charakterisierenden Parameters 26 mittels der Erfassungseinrichtung 12. Vorliegend ist insbesondere weiterhin dargestellt, dass auch hierzu eine Datenakquise und Vorverarbeitung 28 vorgesehen sein kann, sowie ein entsprechendes Systemmodell 30. Insbesondere wird somit das Systemmodell 30 insbesondere in Form einer dynamischen Bewertungsgröße basierend auf Belastungen für das elektronische Bauteil 18 im Feld sowie auf Basis des mathematischen Modells 24, welches eine statische Bewertungsgröße für jedes elektronische Bauteil 18 beziehungsweise Baugruppe ausgibt, in die elektronische Recheneinrichtung überführt. In der elektronischen Recheneinrichtung 14 findet wiederum eine Bewertung der Daten statt. Der Zustand 16 wird insbesondere als adaptive Zustandsbestimmung des elektronischen Bauteils 18 ausgegeben.

Als Produktionsdaten 20 können insbesondere Produktions- und Fertigungsqualitätsdaten angesehen werden. Als das elektronische Bauteil 18 aktuell charakterisierende Parameter 26 können beispielsweise elektrische Funktionsdaten, wie zum Beispiel elektrische Spannungen, und Umweltdaten, wie zum Beispiel Umgebungstemperaturen, erfasst werden.

Insbesondere erfolgt somit ein Bestimmen des Zustands 16 in Abhängigkeit von den bereitgestellten Produktionsdaten 20 und dem zumindest ein das elektronische Bauteil 18 charakterisierenden Parameter 26 mittels der elektronischen Recheneinrichtung 14.

Insbesondere kann vorgesehen sein, dass in Abhängigkeit von dem bestimmten Zustand 26 eine Ausfallwahrscheinlichkeit des elektronischen Bauteils 18 und/oder eine Lebensdauerprognose des elektronischen Bauteils 18 bestimmt werden.

Ferner kann vorgesehen sein, dass als Produktionsdaten 20 qualitätssichernde Daten während einer Fertigung des elektronischen Bauteils 18 bereitgestellt werden. Insbesondere können beispielsweise Produktionsdaten 20 mittels einer optischen Erfassungseinrichtung, beispielsweise mittels einer Kamera, und/oder mittels einer röntgenstrahlungsbasierten Erfassungseinrichtung und/oder mittels einer spannungsbasierten Erfassungseinrichtung erfasst werden. Als Produktionsdaten 20 kann insbesondere eine Nassschichtdicke des elektronischen Bauteils 18 und/oder ein Reflow-Temperaturprofil des elektronischen Bauteils 18 und/oder ein Abstehen eines Bauteils beim elektronischen Bauteil 18 und/oder eine Verkippung des Bauteils beim elektronischen Bauteil 18 und/oder eine Ausprägung eines Lötmeniskus am elektronischen Bauteil 18 und/oder eine Lötstellenqualität erfasst werden.

Ferner kann vorgesehen sein, dass für das elektronische Bauteil 18 das mathematische Modell 24 für die Ausfallwahrscheinlichkeit auf Basis von vorgegebenen Abhängigkeiten 32 bereitgestellt wird und die Produktionsdaten 20 in Abhängigkeit von dem mathematischen Modell 24 ausgewertet werden.

Des Weiteren kann vorgesehen sein, dass zusätzlich ein Gesamtzustand eines elektronischen Systems mit zumindest einem ersten elektronischen Bauteil und einem zweiten elektronischen Bauteil in Abhängigkeit einer jeweiligen Zustandsbestimmung der elektronischen Bauteile bestimmt wird.

Ferner kann vorgesehen sein, dass in Abhängigkeit von der Bestimmung des Zustands 16 eine Wartungsempfehlung des elektronischen Bauteils 18 erzeugt wird und/oder in Abhängigkeit von der Bestimmung des Zustands 16 eine Betriebsart des elektronischen Bauteils 18 adaptiert wird.

Insbesondere zeigt somit die FIG 1 eine hybride, insbesondere KI-basierte Systemmodellierung zur Ermittlung des Zustands 16 des elektronischen Bauteils 18 auf Basis statischer Daten und dynamischer Daten. In dem so genannten statischen Datenpfad werden unter anderem qualitätsrelevante Inspektionsdaten aus der Elektronik-Fertigung ausgewertet, um eine zuverlässigkeitsrelevante Bewertungsgröße für jede produzierte Einheit, insbesondere für jedes produzierte elektronische Bauteil 18, zu ermitteln. Dazu wird das mathematische Modell 24 erstellt, das eine Abhängigkeit des Ausfallzeitpunktes einer Baugruppe für Produktions- und Inspektionsparametern herstellt.

Im dynamischen Datenpfad werden während der gesamten Nutzungszeit des elektronischen Bauteils 18 im Feld funktionelle elektrische Betriebsdaten und Umweltdaten erfasst und ausgewertet. Alterungsabhängige Degradationseigenschaften sind im Systemmodell 30 abgebildet und können mit Betriebs- und Belastungsdaten an die realen Verhältnisse angepasst werden. Das Systemmodell 30 kann aus physikalisch modellierten und KI-basierten Bestandteilen ausgebildet sein und führt eine Zuverlässigkeitsbewertung anhand der Eingangsgrößen durch.

Die elektronische Recheneinrichtung 14 weist einen entsprechenden Algorithmus auf, der beide Datenpfade kombiniert und den Zustand 16 des elektronischen Bauteils 18 kontinuierlich bestimmt.

### Bezugszeichenliste

- 10: Zustandsbestimmungsvorrichtung
- 12: Erfassungseinrichtung
- 14: elektronische Recheneinrichtung
- 16: Zustand
- 18: elektronisches Bauteil
- 20: Produktionsdaten
- 22: Datenakquise und Vorverarbeitung
- 24: mathematisches Modell
- 26: das elektronische Bauteil aktuell charakterisierender Parameter
- 28: Datenakquise und Vorverarbeitung
- 30: Systemmodell
- 32: Abhängigkeit

## Patentansprüche

1. Verfahren zum Bestimmen eines Zustands (16) eines elektronischen Bauteils (18) mittels einer Zustandsbestimmungsvorrichtung (10), mit den Schritten:
- Bereitstellen von Produktionsdaten (20) des elektronischen Bauteils (18) für eine elektronische Recheneinrichtung (14) der Zustandsbestimmungsvorrichtung (10);
- Erfassen von zumindest einem das elektronische Bauteil (18) aktuell charakterisierenden Parameters (26) mittels einer Erfassungseinrichtung (12) der Zustandsbestimmungsvorrichtung (10); und
- Bestimmen des Zustands (16) in Abhängigkeit von den bereitgestellten Produktionsdaten (20) und dem zumindest einen das elektronische Bauteil (18) aktuell charakterisierenden Parameter (26) mittels der elektronischen Recheneinrichtung (14).

2. Verfahren nach Anspruch 1, **dadurch gekennzeichnet, dass** in Abhängigkeit von dem bestimmten Zustand (16) eine Ausfallwahrscheinlichkeit des elektronischen Bauteils (18) und/oder eine Lebensdauerprognose des elektronischen Bauteils (18) bestimmt wird.

3. Verfahren nach Anspruch 1 oder 2, **dadurch gekennzeichnet, dass**
die elektronische Recheneinrichtung (14) mit einer künstlichen Intelligenz bereitgestellt wird.

4. Verfahren nach einem der vorhergehenden Ansprüche, **dadurch gekennzeichnet, dass**
als Produktionsdaten (20) qualitätssichernde Daten während einer Fertigung des elektronischen Bauteils (18) bereitgestellt werden.

5. Verfahren nach einem der vorhergehenden Ansprüche, **dadurch gekennzeichnet, dass**
mittels einer optischen Erfassungseinrichtung und/oder mittels einer röntgenstrahlungsbasierten Erfassungseinrichtung und/oder mittels einer spannungsbasierten Erfassungseinrichtung die Produktionsdaten (20) erfasst werden.

6. Verfahren nach einem der vorhergehenden Ansprüche, **dadurch gekennzeichnet, dass**
als Produktionsdaten (20) eine Nassschichtdicke einer Lotpaste des elektronischen Bauteils (18) und/oder ein Reflow-Temperaturprofil eines Lötprozesses des elektronische Bauteils (18) und/oder ein Abstehen eines Bauteils beim elektronischen Bauteil (18) und/oder eine Verkippung des Bauteils beim elektronischen Bauteil (18) und/oder eine Ausprägung eines Lotmeniskus am elektronischen Bauteil (18) und/oder eine Lötstellenqualität am elektronischen Bauteil (18) erfasst werden

7. Verfahren nach einem der vorhergehenden Ansprüche, **dadurch gekennzeichnet, dass**
für das elektronische Bauteil (18) ein mathematisches Modell (24) für die Ausfallwahrscheinlichkeit auf Basis von vorgegebenen Abhängigkeiten (32) bereitgestellt wird und die Produktionsdaten (20) in Abhängigkeit von dem mathematischen Modell (24) ausgewertet werden.

8. Verfahren nach einem der vorhergehenden Ansprüche, **dadurch gekennzeichnet, dass**
als der das elektronische Bauteil (18) aktuell charakterisierende Parameter (26) ein Umgebungsparameter des elektronischen Bauteils (18) und/oder aktuelle elektrische Betriebsdaten des elektronischen Bauteils (18) erfasst werden.

9. Verfahren nach einem der vorhergehenden Ansprüche, **dadurch gekennzeichnet, dass**
der Zustand (16) des elektronischen Bauteils (18) kontinuierlich bestimmt wird.

10. Verfahren nach einem der vorhergehenden Ansprüche, **dadurch gekennzeichnet, dass**
zusätzlich ein Gesamtzustand eines elektronischen Systems mit zumindest einem ersten elektronischen Bauteil (18) und einem zweiten elektronischen Bauteil (18) in Abhängigkeit einer jeweiligen Zustandsbestimmung der elektronischen Bauteile (18) bestimmt wird.

11. Verfahren nach einem der vorhergehenden Ansprüche, **dadurch gekennzeichnet, dass**
in Abhängigkeit von der Bestimmung des Zustands (16) eine Wartungsempfehlung des elektronischen Bauteils (18) erzeugt wird.

12. Verfahren nach einem der vorhergehenden Ansprüche, **dadurch gekennzeichnet, dass**
in Abhängigkeit von der Bestimmung des Zustands (16) eine Betriebsart des elektronischen Bauteils (18) adaptiert wird.

13. Computerprogrammprodukt mit Programmcodemitteln, welche eine elektronische Recheneinrichtung (14) dazu veranlassen, wenn die Programmcodemittel von der elektronischen Recheneinrichtung (14) abgearbeitet werden, ein Verfahren nach einem der Ansprüche 1 bis 12 durchzuführen.

14. Computerlesbares Speichermedium mit einem Computerprogrammprodukt nach Anspruch 13.

15. Zustandsbestimmungsvorrichtung (10) zum Bestimmen eines Zustands (16) eines elektronischen Bauteils (18), mit zumindest einer elektronischen Recheneinrichtung (14) und einer Erfassungseinrichtung (12), wobei die Zustandsbestimmungsvorrichtung (10) zum Durchführen eines Verfahrens nach einem der Ansprüche 1 bis 12 ausgebildet ist.
